Europäisches Patentamt

European Patent Office

Office européen des brevets

(11) Veröffentlichungsnummer: **0 262 084**
**A2**

## (12) EUROPÄISCHE PATENTANMELDUNG

(21) Anmeldenummer: **87730112.7**

(22) Anmeldetag: **24.09.87**

(51) Int. Cl.⁴: **H 05 K 7/08**

(30) Priorität: **25.09.86 DE 8625853**

(43) Veröffentlichungstag der Anmeldung:
**30.03.88 Patentblatt 88/13**

(84) Benannte Vertragsstaaten:
**AT BE CH DE ES FR GB GR IT LI NL SE**

(71) Anmelder: **Paul & Siedler GmbH & Co KG**
**Mahlower Strasse 24**
**D-1000 Berlin 44 (DE)**

(72) Erfinder: **Lachmann, Gerhard**
**Zeisspfad 26b**
**D-1000 Berlin 49 (DE)**

(74) Vertreter: **Christiansen, Henning, Dipl.-Ing. et al**
**CHRISTIANSEN & NINNEMANN Dietrich-Schäfer-Weg 21**
**D-1000 Berlin 41 (DE)**

(54) **Elektrotechnisches Bauelement.**

(57) In eine Aussparung einfügbares elektrotechnisches Bauelement mit einem eine Stirnfläche mit einem Befestigungselement aufweisenden im wesentlichen becherförmigen Gehäuse, wobei das Befestigungselement einen T-förmigen Querschnitt aufweist oder pilzförmig ausgebildet ist und mit dem stielartigen Teil an der Stirnfläche befestigt ist, und der im wesentlichen quer zum Stiel gerichtete Teil derart ausgebildet ist, daß mindestens ein sich in einer Richtung parallel zur Stirnfläche erstreckender Kantenbereich sich dieser Stirnfläche kontinuierlich bis auf einen Restabstand annähert, um diesen Abstand für mindestens einen Teil einer Restlänge beizubehalten.

Fig.1c

EP 0 262 084 A2

**Beschreibung**

Elektrotechnisches Bauelement

Die Erfindung betrifft ein Bauelement der im Oberbegriff des Anspruchs 1 angegebenen Art sowie eine entsprechende Aufnahme.

Derartige Bauelemente enthalten als elektromechanische und elektronische Baugruppen Bauteile, welche insgesamt in eine grössere Einheit eingefügt werden sollen, wobei im Servicefall das gesamte Bauelement ausgetauscht wird.

Der im kennzeichnenden Teil des Anspruchs 1 angegebenen Erfindung liegt die Aufgabe zugrunde, bei einem Bauelement der eingangs genannten Gattung die Montagehandhabung zu vereinfachen, so daß das Bauelement ohne weiteres eine definierte Endposition einnimmt und bei den im Betrieb auftretenden Massenkräften des Gerätes unverrückbar gehalten ist. Darüber hinaus soll auch der geräteseitige Befestigungsaufwand gering gehalten sein.

Diese Aufgabe wird durch ein elektrotechnisches Bauelement mit den im kennzeichnenden Teil des Anspruchs 1 genannten Merkmalen gelöst.

Das Bauelement mit einem eine Stirnfläche aufweisenden im wesentlichen becherförmigen Gehäuse ist mit einem parallel zur Stirnfläche gerichteten Befestigungselement versehen, dessen Kontur zunächst senkrecht zur Stirnfläche und dann in entgegengesetzter Richtung viertelkreisförmig und nach zwei Seiten gebogen ist, soweit, daß zwischen dem Befestigungselement und der Stirnfläche ein geringer Spalt bestehen bleibt, derart, daß das Befestigungselement in eine Aussparung entsprechender Kontur an einem Trägerelement für das Bauelement einfügbar ist und nach seitlichem Verschieben in den verjüngten Teil der Aussparung, dieser Aussparung benachbarte Randbereiche nach Art eines federnden Nutensteines hintergreift, wobei sich der Spalt zwischen den viertelkreisförmigen Seitenteilen des Befestigungselementes und der Stirnfläche des Gehäuses entsprechend der Materialstärke des Trägerelementes verändert.

Besonders vorteilhaft ist dabei, daß die Montage einhändig und mit einer seitlichen Bewegung durchgeführt werden kann, so daß auch die Anwendung von Handhabungsautomaten in günstiger Weise möglich ist. Es ist kein zusätzlicher Platz beispielsweise für das Ausführen einer Drehbewegung oder eine Werkzeugbetätigung erforderlich.

Bei vorteilhaften Weiterbildungen, wie sie in den Unteransprüchen angegeben sind, arretiert sich das Bauelement selbsttätig. Die Arretierung des Bauelementes hält es sicher an seinem Platz gegenüber beliebigen Kräften und Momenten mit Ausnahme eines Kippmomentes, welches zum Lösen des Bauelementes ausreichend ist. Das Einbringen des Bauelements erfolgt selbstzentrierend, d.h. geringfügige Oberfläche Abweichungen der Positionierung in Richtungen parallel zur Oberfläche des Trägerlements werden infolge der durch die Oberflächengestaltung gebildeten Führungen selbsttätig kompensiert.

Die entsprechende Aufnahme kann in einem Blechteil durch einfaches Stanzen erzeugt werden. Dadurch, daß die Befestigungsvorrichtung an der Stirnfläche des becherförmigen Gehäuses vorgesehen ist, sind die elektrischen Anschlüsse an der von der Befestigungsgrundfläche abgewandten Seite her bequem zugänglich, so daß auch die elektrischen Verbindungen nach Anbringung des Bauelementes durch Handhabungsautomaten hergestellt werden können. Ein Austausch des Bauelementes ist im Servicefall mit zwei Handgriffen möglich.

Andere vorteilhafte Weiterbildungen ermöglichen eine selbsttätige Zentrierung des Bauelementes in d der Endpo sition, so daß eine zusätzlich erleichterte Handhabung gegeben ist.

Das Befestigungselement ist in günstiger Ausführung einstückig mit dem becherförmigen Gehäuse verbunden.

Vorteilhafte Weiterbildungen der Erfindung sind in den Unteransprüchen gekennzeichnet bzw. werden nachstehend zusammen mit der Beschreibung der bevorzugten Ausführung der Erfindung anhand der Figuren näher dargestellt. Es zeigen:

Figuren 1a bis 1c ein Ausführungsbeispiel des mit der erfindungsgemäßen Befestigungsvorrichtung versehenen Bauelementes in drei Ansichten sowie

Figur 2 eine Teilansicht der Trägerplatte als Gegenstück für das Befestigungselement.

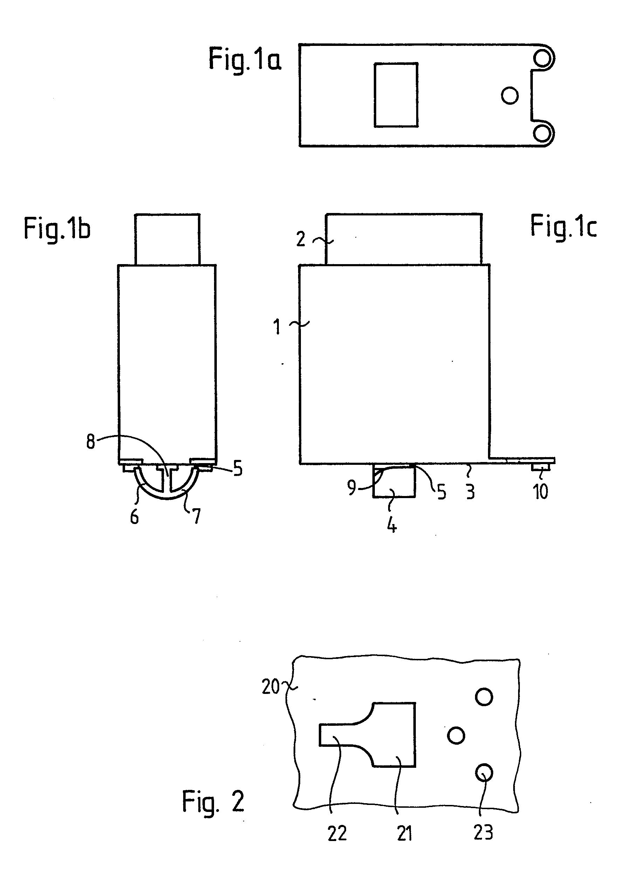

Bei dem in den Figuren 1a bis 1c dargestellten Ausführungsbeispiel stellt die Kappe 1 das becherartige Gehäuse eines Relais dar, dessen Einzelteile nicht im einzelen wiedergegeben sind. Ein Sockel 2 nimmt die elektrischen Anschlüsse auf, die bevorzugt als Steckelemente ausgeführt sind. Diese Elemente stehen zur vereinfachten Handhabung senkrecht vor der diese Elemente tragenden Seitenfläche des Gehäuses, so daß die entsprechenden Handhabungen zum Herstellen der Anschlüsse ebenfalls in dieser Richtung ausgeführt werden können.

An der Stirnfläche 3 ist ein federndes Befestigungselement 4 vorgesehen, welches in seiner parallel zur Stirnfläche 3 gerichteten Erstreckung quadratisch ausgebildet ist und in eine entsprechende Aussparung 21 des Trägerelementes 20 einfüg- bzw. hindurchsteckbar ist.

Das aus einem federelastischen Werkstoff bestehende Befestigungselement hat im Querschnitt die Form eines "T" oder eines Pilzes, dessen Fuß sich senkrecht aus der Stirnfläche heraus erstreckt. Der Fuß bildet einen quaderförmigen Steg 8, der auf einer seiner Schmalseiten steht. Über diesem Steg erstreckt sich ein tonnendachartiges Element, welches sich beidseitig symmetrisch von Steg her in einer Wölbung in Richtung auf die Stirnfläche erstreckt. Die viertelkreisförmigen, federnden Seitenteile 6, 7 enden kurz vor der Stirnfläche und lassen einen Spalt 5 frei, der sich jeweils zur gleichen Seite hin erweitert. Die Kante der Seitenteile geht dabei in gleichmäßiger Verrundung von den der Stirnfläche benachbarten Bereichen in die "Giebelseite" des dachartigen Gebildes über. Die federnden Seitenteile sind somit in Verschieberichtung mit Radien 9 versehne, welche ein Einsetzen des Befestigungselement in die Aussparung des Trägerelements erleichtern.

An der Stirnfläche des Gehäuses 1 befinden sich ein oder mehrere Positionsstifte 10, die in dafür vorgesehene Aussparungen 23 in dem Trägerelement 20 einrasten.

Das Trägerelement 20 besteht aus einem ebenen Blech, welches außer den Ausstanzungen 21, 22, und 23 keinerlei aus der Ebenen hinausweisende Verformung enthält. Das Trägerelement als Aufnahme für ein Bauelement der zuvor beschriebenen Art weist eine Aussparung 21 auf, welche einen dem Querschnitt des Befestigungselements in der Draufsicht auf die Stirnfläche angepaßte Kontur aufweist, wobei sich an diese Kontur - ausgehend von einer Kante, deren Abmessung der Länge des sich quer erstreckenden Elements in der Draufsicht entspricht - ein Bereich 22 anschließt, dessen Breite sich verringert bis auf eine Restbreite, die größer ist als die entsprechende Querabmessung des stielartigen Teils, wobei mindestens der in bezug auf die Ausgangsbreite verringerte Teil Blechstärke aufweist. Die Breite des Erweiterungsbereichs 22 verringert sich beidseitig zu einer Symmetrieachse gleichmäßig und folgt zunächst einer bogenförmigen Kontur, um dann eine geradlinie parallele Begrenzung zu bilden, die mit einer sich rechtwinklig anschließenden Kante endet.

Der Ablauf beim Einsetzen des becherförmigen Gehäuses mit dem erfindungsgemäßen Verriegelungselement geht nun wie folgt vor sich:

Das Gehäuse 1 wird mit seiner Stirnfläche 3 voran mit dem Befestigungselement 4 in den Bereich der Aussparung 21 des Trägerelementes 20 geführt, wobei die Ausrichtung es Gehäuses 1 so gewählt ist, daß die sich an der Stirnfläche 3 befindlichen Positionsstifte 10 und die dafür vorgesehenen Aussparungen 23 im Trägerelement 20 in die gleiche Richtung weisen. Dabei ist bevorzugt das Befestigungselement 4 geringfügig kleiner ausgebildet als die Aussparung 21, so daß bei Berücksichtigung eines für die einfache Handhabung zugrunde zu legenden Toleranzbereiches des Befestigungselement schnell und sicher durch die Aussparung 21 hindurch geführt werden kann. Die Tonnendachform der Elemente 6 und 7 bewirkt ein selbsttätiges Zentrieren beim Einsetzen in die Aussparung 21, 22 in Querrichtung (in Richtung der Sekante der konvexen Verrundung) und die Verjüngung der Aussparung vom Bereich 21 zum Bereich 22 der Aussparungen hin einen Toleranzausgleich in axialer Richtung der Verrundung, da die Umrißkanten der Aussparungen Führungen in Bezug auf das Befestigungselement 4 bilden.

Dieses Hindurchführen erfolgt soweit, bis die Stirnfläche 3 des Gehäuses 1 an der Fläche des Trägerelementes anliegt. Nunmehr ist lediglich ein Verschieben des Gehäuses 1 in die den Positionsstiften 10 entgegengesetzte Richtung erforderlich. Dabei gelangt das Befestigungselement 4 mit seinem Steg 8 in die schmalere Aussparung 22 und hintergreift gleichzeitig mit seinen krallenförmigen federnden Seitenteilen 6, 7 die der Aussparung benachbarten Randbereiche, und hält damit das Gehäuse 1 in dieser Position fest. Gleichzeitig rasten die Positionsstifte 10 in den dafür vorgesehenen Aussparungen 23 ein und arretieren das Gehäuse entgegen der Einschieberichtung.

Soll das Gehäuse des Bauelementes gelöst werden, so braucht es nur leicht angekippt zur werden, dann heben sich die Positionsstifte 10 aus den dafür vorgesehenen Aussparungen heraus. Nun kann das Gehäuse in Richtung der Positionsstifte 10 geschoben werden und durch die Aussparung 21 im Trägerelement 20 entnommen werden.

Die federnde Wirkung des Befestigungselementes 4 ermöglicht die Verwendung des Bauelementes für Trägerelemente mit unterschiedlicher Materialstärke, da sich die federnden Seitenteile der Materialstärke des Trägerelementes anpassen.

Die Erfindung beschränkt sich in ihrer Ausführung nicht auf das vorstehend angegebene bevorzugte Ausführungsbeispiel. Vielmehr ist eine Anzahl von Varianten denkbar, welche von der dargestellten Lösung auch bei grundsätzlich anders gearteten Ausführungen Gebrauch machen.

**Patentansprüche**

1. In eine Aussparung einfügbares elektrotechnisches Bauelement mit einem eine Stirnfläche mit einem Befestigungselement aufweisenden im wesentlichen becherförmigen Gehäuse,

**dadurch gekennzeichnet,**

daß das Befestigungselement (4) einen T-förmigen Querschnitt aufweist oder pilzförmig ausgebildet ist und mit dem stielartigen Teil (8) an der Stirnfläche (3) befestigt ist, wobei der im wesentlichen quer zum Stiel gerichtete Teil (6, 7) derart ausgebildet ist, daß mindestens ein sich in einer Richtung parallel zur Stirnfläche erstreckender Kantenbereich sich dieser Stirnfläche kontinuierlich bis auf einen Restabstand annähert, um diesen Abstand für mindestens einen Teil einer Restlänge beizubehalten.

2. Bauelement nach Anspruch 1, **dadurch gekennzeichnet,** daß der quer zum stielartigen Teil (8) gerichtete Teil (6, 7) im Querschnitt konvex verrundet ausgebildet ist, wobei ihre die Kantenbereiche aufweisenden freien Enden zur Stirnfläche (3) hin weisen.

3. Bauelement nach Anspruch 2, **dadurch gekennzeichnet,** daß der quer zum Stiel gerichtete Teil entsprechend der Wandung eines Hohlzylinders ausgebildet ist.

4. Bauelement nach einem der vorangehenden Ansprüche, **dadurch gekennzeichnet,** daß der stielartige Teil einen quaderförmigen Steg bildet.

5. Bauelement nach einem der vorangehenden Ansprüche, **dadurch gekennzeichnet,** daß an der Stirnfläche (3) des Gehäuses (1) ein Befestigungselement (4) vorgesehen ist, welches in einer senkrecht zur Stirnfläche gerichteten Schnittebene eine Kontur aufweist, die sich im Querschnitt zunächst senkrecht von Stirnfläche entfernt und dann ausgehend vom Bereich der höchsten Erhebung auf einem Viertelkreisbogen fast bis zur Stirnfläche zurückerstreckt, wobei zwischen der Kante des Befestigungselements (4) und der Stirnfläche (3) ein Restabstand (5) verbleibt, der in einer senkrecht zur ersten gerichteten weiteren ebenfalls senkrecht zur Stirnfläche gerichteten Schnittebene gesehen zu einer Seite hin vergrößert ist.

6. Bauelement nach einem der vorangehenden Ansprüche, **dadurch gekennzeichnet,** daß das Befestigungselement (4) aus federelastischem Material, insbesondere aus Bronzeblech oder Kunststoff besteht.

7. Bauelement nach einem der vorangehenden Ansprüche, **dadurch gekennzeichnet,** daß die das Befestigungselement (4) in der Draufsicht auf die Stirnfläche eine mehreckige, insbesondere quadratische oder rechteckige Kontur aufweist.

8. Bauelement nach einem der vorangehenden Ansprüche, **dadurch gekennzeichnet,** daß das stielartige Element in der Draufsicht auf die Stirnfläche eine mehreckige, insbesondere quadratische oder rechteckige Kontur aufweist.

9. Bauelement nach einem der vorangehenden Ansprüche, **dadurch gekennzeichnet,** daß an der Stirnfläche (3) mindestens ein die Stirnfläche überragender Positionsstift (10) oder eine entsprechende Aussparung vorgesehen ist.

10. Aufnahme für ein Bauelement nach einem der vorangehenden Ansprüche, **dadurch gekennzeichnet,** daß eine Aussparung vorgesehen ist, welche einen dem Querschnitt des Befestigungselements (4) in der Draufsicht auf die Stirnfläche angepaßte Kontur aufweist, wobei sich an diese Kontur - ausgehend von einer Kante, deren Abmessung der Länge des sich quer erstreckenden Elements in der Draufsicht entspricht - ein Bereich anschließt, dessen Breite sich verringert bis auf eine Restbreite, die größer ist als die entsprechende Querabmessung des stielartigen Teils, wobei mindestens der in bezug auf die Ausgangsbreite verringerte Teil Blechstärke aufweist.

11. Aufnahme nach Anspruch 10, **dadurch gekennzeichnet,** daß die Breite sich beidseitig gleichmäßig, insbesondere einer bogenförmigen Kontur folgend - verringert.

12. Aufnahme nach einem der Ansprüche 10 oder 11, **dadurch gekennzeichnet,** daß mindestens ein die Aufnahme überragender Positionsstift oder eine entsprechende Aussparung (23) vorgesehen ist.

PS 36.2

0262084

Fig.1a

Fig.1b

Fig.1c

2

1

8

5

6   7

9   5  3   10

4

Fig. 2

20

22   21   23